(19) Europäisches Patentamt
European Patent Office
Office européen des brevets

(11) Publication number: **0 287 661**
**A1**

(12) # EUROPEAN PATENT APPLICATION

published in accordance with Art. 158(3) EPC

(21) Application number: 87901112.0

(22) Date of filing: 28.01.87

Data of the international application taken as a basis:

(86) International application number:
PCT/JP87/00061

(87) International publication number:
WO87/04608 (13.08.87 87/18)

(51) Int.Cl.³: A 61 B 5/05
A 61 B 10/00, G 01 N 24/08
G 01 R 33/20

(30) Priority: 29.01.86 JP 17371/86

(43) Date of publication of application:
26.10.88 Bulletin 88/43

(84) Designated Contracting States:
DE GB

(71) Applicant: YOKOGAWA MEDICAL SYSTEMS, LTD
1-3, Sakaecho 6-chome Tachikawa-shi
Tokyo 190(JP)

(72) Inventor: SHIMAZAKI, Toru Yokogawa Medical Systems Ltd.
1-3, Sakaecho 6-chome Tachikawa-shi
Tokyo 190(JP)

(74) Representative: Henkel, Feiler, Hänzel & Partner
Möhlstrasse 37
D-8000 München 80(DE)

(54) **SCAN CONTROLLER FOR NMR IMAGING APPARATUS.**

(57) A scan controller for NMR imaging apparatus which stores control signals having high amplitude resolution for a variety of sequences using small amounts of memory, and which easily assembles any sequence. The waveforms of the control signals are stored in a waveform memory (101) while the amplitude thereof are stored in an amplitude memory (102) in the order of events in the sequence, and the duration designating values thereof are stored in a time memory (103) in the order of events in the sequence. The waveform memory (101) is read by an address counter (104) which operates on clocks determined by values read from the time memory (103), and the output thereof is converted through a first D/A converter (105) into an analog signal and is produced. At this moment, the amplitude of the output signal of the first D/A converter (105) is determined by applying a stored amplitude read from the amplitude memory (102) for every event as a fullscale value to the first D/A converter (105) through a second D/A converter (106).

WAVE FORM MEMORY
101
105
D/A
ADDRESS COUNTER
104
106
D/A
133
AMPLITUDE MEMORY
102
DATA BUS
TIME MEMORY
103
CPU
131
MEMORY
132

FIG. 2

EP 0 287 661 A1

Croydon Printing Company Ltd.

# SPECIFICATION

# SCAN CONTROLLER FOR NMR IMAGING DEVICE

(Technical Field)

This invention is related to an improved scan controller for imaging devices that acquire tomographic images of a subject by using nuclear magnetic resonance. In other words, this invention is related to the scan controller for NMR imaging devices with improved memory performance for scan control signals.

(Background Art)

The NMR imaging device has a magnet assembly that includes a static magnetic field coil to generate a uniform static magnetic field, and a gradient magnetic field coil that generates straight and gradient magnetic fields (in the same magnetic field as the static magnetic field) in the X, Y, and Z directions. Also included are transmitting and receiving sections that detect NMR signals from the subject by applying a high-frequency pulse (RF electromagnetic wave) to the magnetic field generated by the magnetic assembly, and a control and image processing section that controls the transmitting/receiving sections and magnetic assembly, and processes the detected data for image display.

When controlled by the control and image processing section, this NMR imaging device sequentially outputs high-frequency pulses based on the Saturation Recovery method or Inversion Recovery method. The control and image processing sections also control the magnet assembly and transmitting/receiving sections to restore images through sequential data collection based on Fourier analysis, for example.

The control and image processing section is equipped with a scan controller. The scan controller generates a gradient magnetic field and high-frequency pulse according to the respective operation sequences of the magnet assembly and transmitting/receiving sections. Control signals used to generate the gradient magnetic field and high-frequency pulse according to sequence are stored in advance, and are read to execute the sequence. Stored control signals have different waveforms, amplitudes, and continuation times according to the type of sequence. Therefore, the scan controller requires large memory capacity to store consecutive control signals. Furthermore, to enhance the resolution of the control signal amplitude, digital data uses a number of bits to express the amplitude. This in turn increases the use of memory.

(Disclosure of Invention)

An object of this invention is to provide a scan controller for NMR imaging devices that can store control signals of high-amplitude resolution for various sequences using a small memory capacity.

Another object of the invention is to provide a scan controller for NMR imaging devices that can randomly assemble sequences.

The scan controller related to this invention stores the waveforms of control signals in waveform memory 101. The controller also stores the amplitudes of control signals in amplitude memory 102, and stores the specified continuation time value of control signals in time memory 103 in order of sequence events.

The scan controller reads waveform memory 101 by using address counter 104, which operates based on a clock determined by the value read from time memory 103. The scan controller converts the output into an analog signal by using the first D/A converter 105. The amplitute of the signal output from the first D/A converter 105 is determined by assigning it the memory value of the amplitude read from amplitude memory 102 for individual events (through the second D/A converter 106) as the full-scale value.

(Brief Description of Drawings)

Figure 1 is a block diagram of the NMR imaging device for which the scan controller of this invention is used.

Figure 2 is a block diagram that shows the embodiment of this invention.

Fig. 3 is a pulse sequence that shows an example of operating the NMR imaging device shown in Fig. 1.

(Best Mode for Carrying out the Invention)

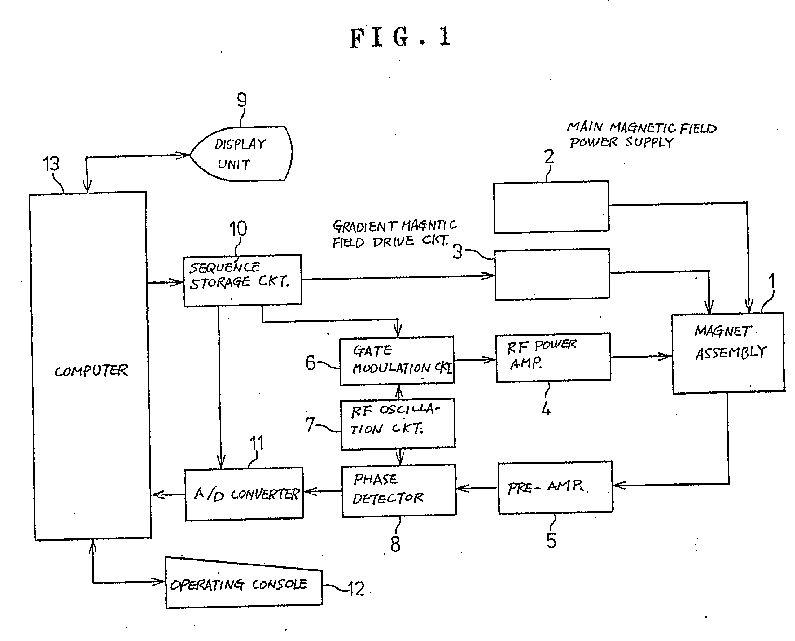

Turning now to the drawings, Fig. 1 is a block diagram showing the embodiment of this invention. Magnet assembly 1 has an internal space section for inserting the subject. This space section is surrounded by a static magnetic field coil that applies a fixed static magnetic field to the subject, X, Y, and Z gradient magnetic field coils to generate gradient magnetic fields, an RF transmitting coil to provinde high-frequency pulses for exciting nuclear spin inside the subject, and a receiving coil to detect NMR signals from the subject (Fig. omitted). The static magentic field coil, gradient magnetic field coils, RF transmitting coil, and receiving coil are respectively connected to main magnetic field power supply 2, gradient magnetic field drive circuit 3, RF power amplifier 4, and pre-amplifier 5. Sequence storage circuit 10 operates gradient magnetic field drive circuit 3, gate modulation circuit 6 and A/D converter 11 according to instructions issued from computer 13 in the preset sequence. Phase detector 8 refers to the output from RF oscillation circuit 7 as a signal, then provides A/D converter 11 with the NMR signal that is detected by the receiving coil and sent via pre-amplifier 5 after phase detection. A/D converter 11 inputs the NMR signal provided by phase detector 8 after analog-to-digital conversion to computer 13. Computer 13 exchanges data between operating console 12, and switches the operation of sequence storage circuit 10 or reloads its memory to set various scan sequences. Computer 13 uses the data sent from A/D converter 11 to execute the carries out operations for reconfiguring the distribution of information on resonance energy into images, and outputs this reconfigured image data to display unit 9.

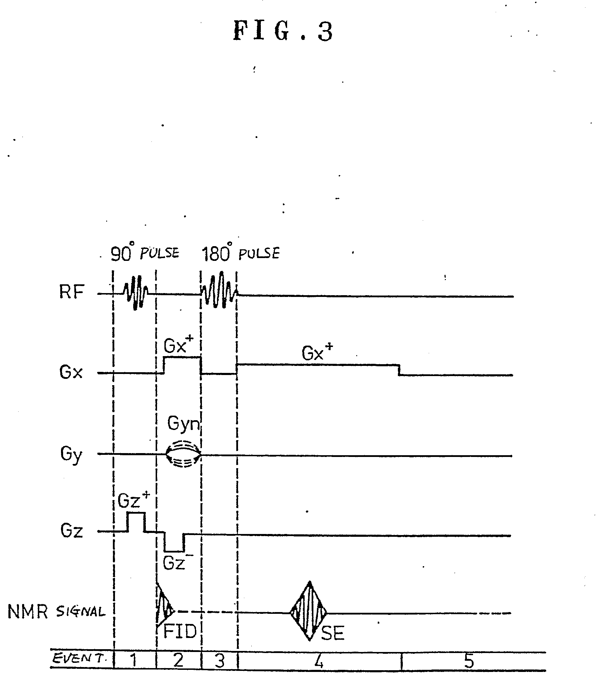

Sequence storage circuit 10 contains the scan controller of this invention (described later), and executes scanning in the sequence shown in Fig. 3 through scan controller operation. Figure. 3 is a waveform diagram of data collection through scanning according to Fourier's pulse sequence (RF denotes a high-frequency pulse; $G_x$, $G_y$, and $G_z$ indicate gradient magnetic fields). The gradient magnetic field functions are divided into $G_x$ for the readout gradient, $G_y$ for the warp gradient, and $G_z$ for the slice positioning gradient. The NMR signal shows the FID signal after a $90^o$ pulse, and the Spin Echo signal (SE signal) after a $120^o$ pulse.

The sequence is divided by events that generate individual pulses that are numbered. In Event 1, spins in the slice surfaces vertical to axis z (centered at z=0) are excited by a $90^o$ pulse and gradient magnetic field $G_z^+$.

The envelope of the $90^o$ pulse is used for the sine-wave function, for example. In Event 2, $G_x^+$, $G_{yn}$, and $G_z^-$ are applied. $G_{yn}$ shifts the phase of the spin in proportion to the directional position of y through an operation called a warp, while the strength of such operation is controlled to be different for each view. In Event 3, a $180^o$ pulse is applied. The envelope of this $180^o$ pulse is also used for the function, for example. In Event 4, the SE signal is measured while applying gradient magnetic field $G_x^+$.

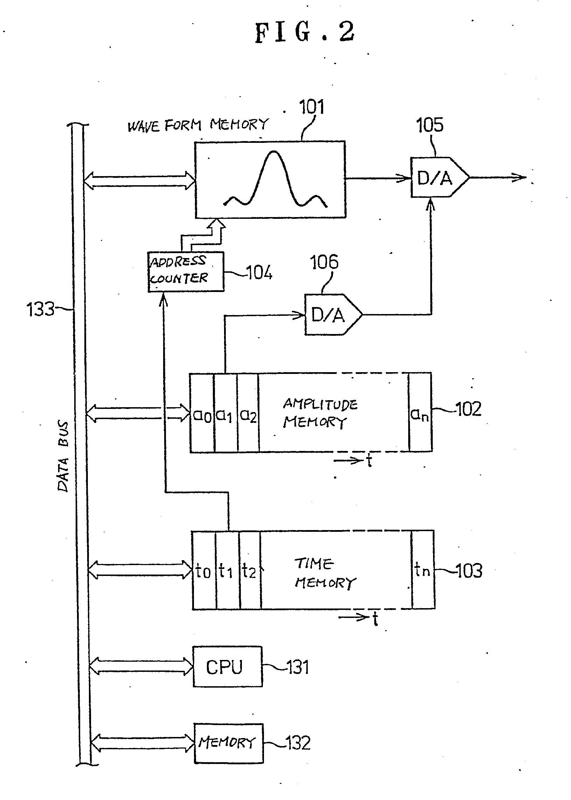

As described thus far, a high-frequency pulse and gradient magnetic field are generated for each event according to the control signals of specific waveforms. The control signals of these waveforms, for example, are generated by the scan controller as shown in Fig. 2. In Fig. 2, 101 is the waveform memory storing the control signal waveform. The memory consists of four sets: one for each of the RF, $G_x$, $G_{yn}$, and $G_z$ waveforms. Figure 2 shows the waveform memory for RF as a typical example. The RF pulse envelope for one event is written to waveform memory 101 as a waveform consisting of N steps. The values of individual waveform steps stored in waveform memory 101 are sequentially read according to the address specified by address counter 104. Address counter 104 is provided in four sets corresponding to the four sets of waveform memory 101. Figure 2 only shows one of them. Digital data read from waveform memory 101 is converted into an analog signal by the first D/A converter 105 for output as the control signal. Amplitude memory 102 stores the amplitudes of control signals stored in waveform memory 101 (in the order of events) in the form of multiplicance. The multiplying factor of amplitude includes zero and a negative value. Amplitude memory 102 is also provided in four sets corresponding to the four sets of waveform memory. Figure 2 only shows one of them. Digital data read from amplitude memory 102 is converted into an analog signal by the second D/A converter 106 for application to the first D/A converter 105 for its full-scale setting value. Consequently, the value of the output signal from the first D/A converter 105 becomes equal to the product of multiplying the storage value of waveform memory 101 by the corresponding value of amplitude memory 102. These two storage values may be multiplied by each other in the digital signal stage for subsequent conversion into an analog signal.

Time memory 103 stores the data that defines the time axis length of one waveform stored in waveform memory 101 or the continuation time of the control signal for one event (in order of events). Time memory 103 also consists of four sets that correspond to those of four-set waveform memory 101. In Fig. 2, time memory 103 stores the data during the cycle of the clock signal input to address counter 104. A short clock cycle is stored for the control signal of a short continuation time, while a long clock cycle is stored for one with a long continuation time.

Waveform memory 101, amplitude memory 102, and time memory 103 are connected to CPU131 and memory 132 inside computer 13 by data bus 133, and are controlled by CPU131. Consequently, the contents of these memories can be reloaded by CPU131. Storage data in amplitude memory 102 and time memory 103 are simultaneously read by a common event number provided by CPU131. Event number is incremented by one when an event is terminated.

For this type of scan controller, four sets of waveform memory 101 each store the waveform for one event for RF, $G_x$, $G_{yn}$, and $G_z$ to be used in the sequence shown in Fig. 3. The four sets of amplitude memory 102 store the amplitude multiplying factors for the events of individual signals. Time memory 103 stores the clock cycle read from respective waveform memories for individual events. Thus, the sequence shown in Fig. 3 is executed by CPU131, while it consecutively updates the event number at a specific timing. The scan controller for this invention has the following characteristics:

The amplitude and continuation time of control signals are respectively stored in amplitude memory 102 and time memory 103. Therefore, the control signal to be stored in waveform memory 101 may be one type, regardless of the amplitude and continuation time or number of events, (as long as the waveform is the same). This can largely reduce the number of memories used to store control signals.

Because the control signal will be the product of the storage value of waveform memory 101 multiplied by the storage value of amplitude memory 103, the number of control signal bits will be the sum of the bits of both storage values. Therefore, a control output of high-amplitude resolution can be obtained without increasing the number of bits for the storage value of waveform memory 101.
If executing an other sequence using the same waveform, only the contents of amplitude memory 102 and time memory 103 should be reloaded. If executing a sequence using an other waveform, the waveform of waveform memory 101 should be reloaded or the required waveform should be selected from the preloaded waveforms. Therefore, sequences can be randomly and easily assembled.
The ideal mode for the embodiment of this invention is illustrative and not restrictive, and the scope of the invention indicated by appended claims and all variations within the meaning of such claims can be easily determined by those possessing knowledge in the technical fields to which this invention applies.

CLAIMS

1. A scan controller has been developed for NMR imaging devices, to control high-frequency pulses and/or gradient magnetic fields in a pulse sequence for NMR imaging configured by a series of multiple events). It consits of the following:

waveform memory (101) to store control signal waveforms, amplitude memory (102) to store control signal amplituds in order of sequence events,

time memory (103) to store the specified values of control signal continuation times in order of sequence events,

amplitude memory and time memory (131) readout to read amplitude memory and time memory according to the order of events, waveform memory (104) readout being based on a clock determined by the value read from time memory, and the storage value read from waveform memory, and

the means to output the product of waveform memory and amplitude memory readout values (105 and 106).

2. Waveform memory readout is done by the scan controller for NMR imaging devices (as described in Item 1 of the present Claim) using an address counter for counting clocks.

3. Output is done by the scan controller for NMR imaging devices (as described in Item 1 of the present Claim) using the first D/A converter that converts the waveform memory readout value into an analog signal, and the second D/A converter that converts the amplitude memory readout value into an analog signal to become the full-scale setting value for the first D/A converter.
4. Output is done by the scan controller for NMR imaging devices (as described in Item 1 of the present Claim) by converting the product of the waveform memory and amplitude memory readout values into an analog signal.

MAIN MAGNETIC FIELD POWER SUPPLY
2
GRADIENT MAGNTIC FIELD DRIVE CKT.
3
MAGNET ASSEMBLY
1
RF POWER AMP.
4
PRE- AMP.
5
GATE MODULATION CKT.
6
RF OSCILLA-TION CKT.
7
PHASE DETECTOR
8
DISPLAY UNIT
9
SEQUENCE STORAGE CKT.
10
A/D CONVERTER
11
OPERATING CONSOLE
12
COMPUTER
13

FIG. 1

FIG. 2

WAVE FORM MEMORY
101
105
D/A
ADDRESS COUNTER
104
106
D/A
133
DATA BUS
$a_0$
$a_1$
$a_2$
AMPLITUDE MEMORY
$a_n$
102
t
$t_0$
$t_1$
$t_2$
TIME MEMORY
$t_n$
103
t
CPU
131
MEMORY
132

FIG. 3

90° PULSE
180° PULSE
RF
Gx
Gx+
Gx+
Gy
Gyn
Gz
Gz+
Gz−
NMR SIGNAL
FID
SE
EVENT
1
2
3
4
5

# INTERNATIONAL SEARCH REPORT

International Application No PCT/JP87/00061

**I. CLASSIFICATION OF SUBJECT MATTER** (if several classification symbols apply, indicate all) [3]

According to International Patent Classification (IPC) or to both National Classification and IPC

Int.Cl[4] A61B5/05, A61B10/00, G01N24/08, G01R33/20

**II. FIELDS SEARCHED**

Minimum Documentation Searched [4]

| Classification System | Classification Symbols |
|---|---|
| IPC | A61B5/05, A61B10/00, G01N24/08, G01R33/20 |

Documentation Searched other than Minimum Documentation to the Extent that such Documents are Included in the Fields Searched [5]

**III. DOCUMENTS CONSIDERED TO BE RELEVANT** [14]

| Category* | Citation of Document, [16] with indication, where appropriate, of the relevant passages [17] | Relevant to Claim No. [18] |
|---|---|---|
| Y | JP, A, 60-242352 (General Electric Co.) 2 December 1985 (02. 12. 85) & EP, A, 152879 | 1-4 |
| Y | JP, A, 60-82841 (Yokogawa Hokushin Electric Corporation) 11 May 1985 (11. 05. 85) & GB, A, 8425240 & DE, A, 3437509 | 1-4 |
| Y | JP, A, 60-80747 (Utsunomiya Daigaku-cho) 8 May 1985 (08. 05. 85) & GB, A1, 2149921 | 1-4 |
| Y | JP, A, 60-78338 (The Regents of the University of California) 4 May 1985 (04. 05. 85) & EP, A2, 132336 | 1-4 |

* Special categories of cited documents: [15]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search [2] | Date of Mailing of this International Search Report [2] |
|---|---|
| March 2, 1987 (02. 03. 87) | March 16, 1987 (16. 03. 87) |
| **International Searching Authority** [1] | **Signature of Authorized Officer** [20] |
| Japanese Patent Office | |